(19) Europäisches Patentamt
European Patent Office
Office européen des brevets

(11) **EP 2 876 400 B1**

(12) **EUROPEAN PATENT SPECIFICATION**

(45) Date of publication and mention of the grant of the patent:
**05.10.2016 Bulletin 2016/40**

(51) Int Cl.:
***F28D 15/02*** *(2006.01)*

(21) Application number: **13193615.5**

(22) Date of filing: **20.11.2013**

(54) **Cooling element**

Kühlelement

Élément de refroidissement

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**27.05.2015 Bulletin 2015/22**

(73) Proprietor: **ABB Technology Oy**
**00380 Helsinki (FI)**

(72) Inventors:
• **Gradinger, Thomas**
**5405 Baden Daetwill (CH)**

• **Agostini, Bruno**
**5405 Baden Daetwill (CH)**

(74) Representative: **Kolster Oy Ab**
**Iso Roobertinkatu 23**
**PO Box 148**
**00121 Helsinki (FI)**

(56) References cited:
**CN-A- 1 946 276      CN-A- 101 533 810**
**CN-A- 101 566 331   CN-A- 103 000 737**
**KR-A- 20110 090 491   US-A- 5 836 383**
**US-A1- 2009 101 308   US-A1- 2013 077 245**

**Description**

**BACKGROUND OF THE INVENTION**

**FIELD OF THE INVENTION**

This invention relates to a cooling element and more precisely to a cooling element for cooling an electric component.

**DESCRIPTION OF PRIOR ART**

Previously there is known a cooling element with a first surface for receiving an electric component. A second surface of the cooling element is provided with fins for forwarding a heat load received from the electric component via the first surface to surroundings via the fins.

Cooling elements of such a type are typically installed in a horizontal orientation, though also other orientations are possible. A horizontal orientation refers to an orientation where the first surface faces upwards, while the cooling fins protrude downwards. A channel for an airflow may in that case be located between the fins, in other words below the electric component that is attached to the first surface. A drawback with such a cooling element is an insufficient cooling performance. In particular when used in combination with power-semiconductor modules generating significant heat loads during use, it is difficult to ensure a sufficient cooling for the electric component.

Previously there is also known from US 2013077245 A1 a cooling module for cooling electronic components. This module includes a plurality of fins with conduits that are interconnected by a condensate header.

**SUMMARY OF THE INVENTION**

An object of the present invention is to solve the above mentioned drawback and to provide a cooling element with improved capabilities. This and other objects are achieved with a cooling element according to independent claim 1.

The use of a cooling element with fins having flow channels for passing a fluid makes it possible to obtain a cooling element with improved cooling capabilities.

**BRIEF DESCRIPTION OF DRAWINGS**

In the following the present invention will be described in closer detail by way of example and with reference to the attached drawings, in which

Figures 1 a and 1 b illustrate the working principle of a pulsating heat pipe,
Figure 2 illustrates a first embodiment of a cooling element,
Figure 3 illustrates a first embodiment of a fin,
Figures 4 and 5 illustrate a second embodiment of a fin, and
Figures 6 and 7 illustrate a second embodiment of a cooling element.

**DESCRIPTION OF AT LEAST ONE EMBODIMENT**

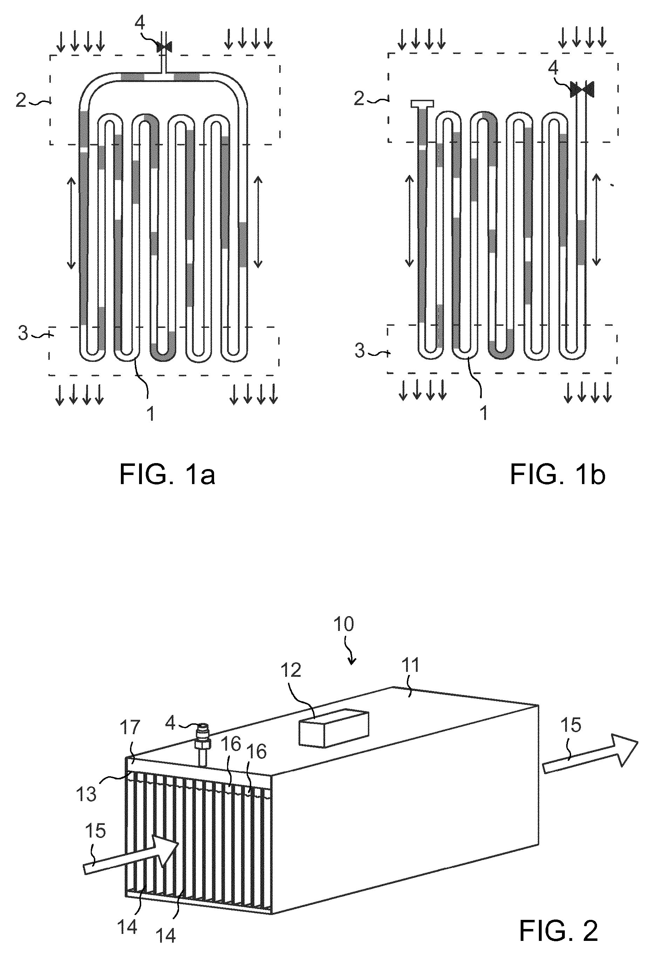

Figures 1 a and 1 b illustrate the working principle of a Pulsating Heat Pipe (PHP). Figure 1 a illustrates a closed-loop PHP and Figure 1b illustrates an open-loop PHP.

A pulsating heat pipe involves a meandering flow channel 1 having a capillary dimension, in other words a cross-section small enough for capillary forces to dominate over gravity forces. A suitable fluid can be introduced into the flow channel 10 via a filling valve 4. As a consequence, the fluid is moved by pulsations generated by pressure instabilities. The oscillations occur in a small channel loop due to the bidirectional expansion of vapour inside the channels. During operation, the liquid slugs and elongated vapour bubbles will oscillate between a cold and a hot region because of hydrodynamic instabilities caused by the rapid expansion of the bubbles confined in the small channels, and thus provide a fluid velocity almost independent of gravity. This makes pulsating heat pipes fairly insensitive to orientation, with the possibility of operating them "upside down", i.e. with an evaporator 2 on top and a condenser 3 at the bottom.

An advantage of utilizing a pulsating heat pipe in a cooling element is that the cooling element can be utilized in any orientation without causing problems for fluid circulation within the cooling element.

Figure 2 illustrates a first embodiment of a cooling element 10. The cooling element 1 comprises a first surface 11 for receiving an electric component 12, such as a power-semiconductor module, which may be attached to the first surface with screws, for instance. One alternative is that the cooling element 10 is a part of a motor drive, such as a frequency controller, controlling supply of electricity to an electric motor. In that case the electric component 12 may be an IGBT (Insulated Gate Bipolar Transistor) module, for instance.

A second surface 13 of the cooling element is provided with fins 14 for forwarding a heat load received from the electric component 12 to surroundings via the fins. In the illustrated example the fins 14 are implemented as elongated plates like elements protruding downwards from the second surface 13 of the cooling element 10. Spacers 16 may be arranged between the fins and in contact with the second surface 13 in order to obtain gaps between the fins. An airflow 15 may be generated to pass between the fins 14 such that the fins dissipate heat into this airflow 15.

In order to obtain an efficient cooling element 10, one or more of the fins are provided with a flow channel 1 for passing a fluid within each respective fin 14.

Preferably each fin has a flow channel, however, in some implementations it may be sufficient to have flow channels only in a part of the fins. In order to avoid that the flow channel 1 of each fin needs to be filled separately, the flow channels 1 of the different fins 14 are in fluid communication with each other. Such a fluid communication may be obtained via the base plate 17 to which the electric component 12 is attached and to which the fins 14 are thermally connected. In such a solution one single filling valve 4 arranged in the first surface of the base plate 17 may be used for introducing fluid into all of the fins 14.

An advantage obtained by having fluid channels in the fins 14 is that a more efficient distribution of heat load to different parts of the fins is achieved. Consequently a significant area of the fins can be efficiently utilized for dissipating heat to surroundings, as the fluid in the fluid channel 1 efficiently transfers heat between different parts of the fins 14.

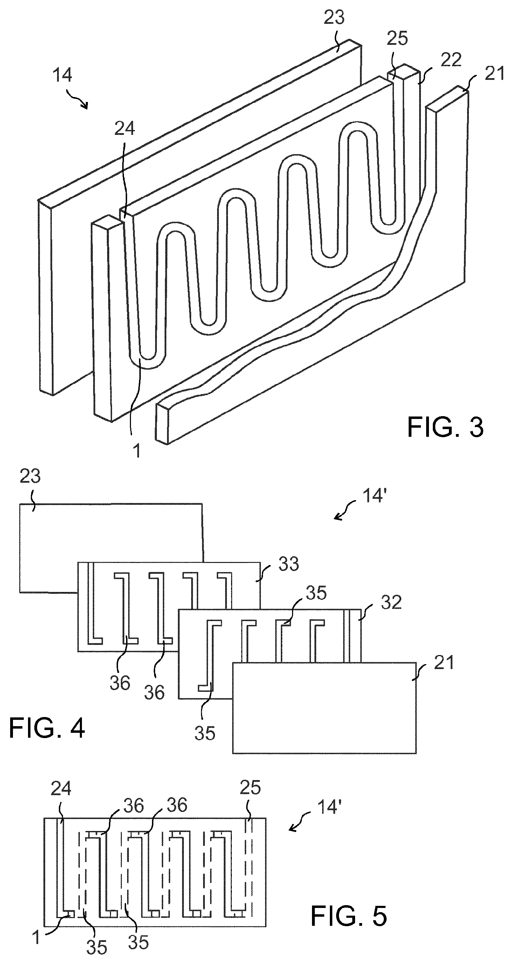

Figure 3 illustrates a first embodiment of a fin 14. The fins used in the embodiment of Figure 2 may be implemented as illustrated in Figure 3.

The illustrated fin 14 comprises a stack of plates 21 to 23 arranged against each other. The middle plate 22 has a slit which works as the fluid channel 1 distributing fluid to different parts of the fin 14. This slit may be manufactured by punching or cutting, for instance. The two outer plates 21 and 23 are non-perforated solid plates which provide fluid tight outer walls for the fin 14 on opposite sides of the middle plate 22.

The fin 14 has two openings 24 and 25 in opposite ends of the flow channel 1. The openings 24 and 25 are arranged in a side edge of the fin 14 which faces the second surface 13 of the cooling element 10. These openings facilitate a fluid communication between the fluid channel 1 of the fin 14 and other parts of the cooling element.

Fluid circulation within the flow channel 1 should be obtained without the need of an external device, such as a pump, and independently of the orientation of the cooling element, thus the flow channel 1 are capillary dimensioned in order to get the fins of the cooling element to work as a pulsating heat pipe. One way to determine whether or not the fluid channel has a capillary dimension is to calculate the Eötvös number, which should be below about 4. Eötvös number EÖ can be calculated as follows:

$$E\ddot{O} = \left( D \cdot \left( g(\rho_{liq} - \rho_{vap})/\sigma \right)^{0,5} \right)^2$$

wherein D is the channel hydraulic diameter, g is the gravitational acceleration, $\rho_{liq}$ is the liquid density, $\rho_{vap}$ is the vapour density, $\sigma$ is the surface tension.

For refrigerant R245fa (1,1,1,3,3-Pentafluoropropane), which may be used as the fluid, a possible choice is a conduit height (= sheet thickness of the middle plate 22) of 1 mm and a conduit width (= width of slit in the middle plate 22) of 2 mm. This results in Eö = 2.2 at a fluid operating temperature of 60 °C, as shown in the table below:

| conduit width | 2 | mm |
|---|---|---|
| conduit height | 1 | mm |
| conduit cross-sectional area | 2 | mm$^2$ |
| conduit perimeter | 6 | mm |
| conduit hydraulic diameter | 1.33 | mm |
| gravitational acceleration | 9.81 | m/s$^2$ |
| type of fluid | R245fa | |
| operating temperature | 60 | °C |
| liquid density | 1'237 | kg/m$^3$ |
| vapor density | 25.7 | kg/m$^3$ |
| surface tension | 9.6 | mN/m |
| Bond number | 1.48 | |
| Eötvös number | 2.20 | |

Figures 4 and 5 illustrate a second embodiment of a fin 14', which may be utilized in a cooling element 10 of Figure 2, for instance. The embodiment of Figures 4 and 5 is very similar to the one explained in connection with Figure 3. Therefore, the embodiment of Figures 4 and 5 will be explained mainly by pointing out the differences between these embodiments. The illustrated fin 14', may be utilized in a cooling element 10 of Figure 2, for instance.

From Figure 4, which illustrates the parts of the fin 14' before assembly, it can be seen that the fin 14' comprises two middle plates 33 and 34 instead on only one middle plate in the embodiment of Figure 3. The first 33 and second 34 middle plates both comprise a plurality of separate slits 35 and 36 shaped and located in such positions that the slits 35 and 36 of the first 33 and second 34 middle plate will together form the fluid channel 1 once the plates are stacked against each other.

Figure 5 illustrates the plates 32 and 33 stacked against each other. From Figure 5 it can be seen that the slits 35 and 36 of the first and second middle plate partly overlap each other such that a continuous fluid channel 1 is provided through the fin 14', similarly as in the embodiment of Figure 3. Similarly as in Figure 3, openings 24 and 25 are arranged in a side edge of the fin 14' which faces the second surface 13 of the cooling element 10.

An advantage obtained with the embodiment of Figures 4 and 5 as compared to the embodiment of Figure 3, is that the middle plates 32 and 33 each consist of one single part only, which makes it easier to handle them during manufacturing, for instance. In Figure 3, the slit forming the fluid channel 1 cuts the middle plate into two separate parts, that need to be located in correct positions during manufacturing.

In order to ensure that the fin 14' and the fluid channel 1 works as a pulsating heat pipe with the same fluid as explained in Figure 3, the thickness of the first 32 and second 33 middle plate may be 1 mm each. The thickness of the outer plates 21 and 23 may be 0.5 mm each, for instance.

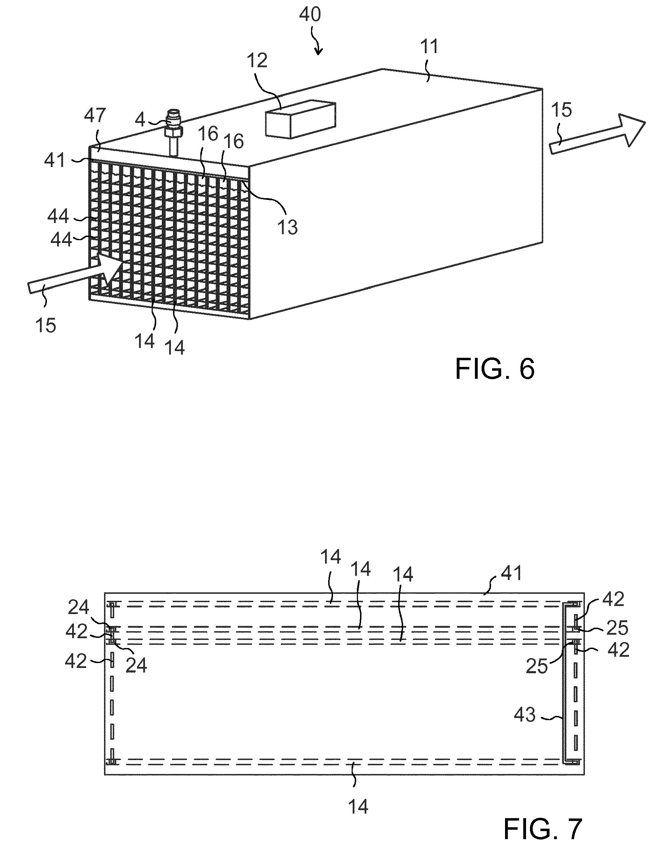

Figures 6 and 7 illustrate a second embodiment of a cooling element 40. The embodiment of Figures 6 and 7 is very similar to the one explained in connection with Figure 2. Therefore the embodiment of Figures 6 and 7 is explained mainly by pointing out the differences between these embodiments

Similarly as in the embodiment of Figure 2, the fins 14 may be of the type illustrated in Figure 3 or of the type illustrated in Figures 4 and 5. In the embodiment of Figures 6 and 7, secondary fins 44 are, however, provided to extend between the illustrated fins 14. Such secondary fins 44, which increase the surface area dissipating heat into the airflow 15, may be utilized also in the embodiment of Figure 2.

In the embodiment of Figures 6 and 7, the cooling element comprises a first plate 47 and a second plate 41 stacked against each other such that the first surface 11 for receiving an electric component 12 and the second surface 13 provided with fins 14 are facing opposite directions.

Figure 7 illustrates the second plate 41 in more detail. The second plate working as a connector plate is provided with through holes 42 at the locations of the openings 24 and 25 of the fins 14. In Figure 7 only four fins 14 are illustrated for simplicity. As can be seen from Figure 7, the holes 42 in the second plate are such arranged and dimensioned that two fins 14 are located at each hole 42, and that one opening 24 of two adjacent fins 14 are in fluid communication via the hole 42 in question. Consequently the holes 42 provide fluid communication between the fluid channels 1 of the different fins. Due to this, the fluid channel of the different fins may be connected to a single closed loop working as a pulsating heat pipe. The first plate 47 may be implemented as a solid base plate that does not need to have any other fluid channels than possibly a bore for the filling valve 4. The first plate 47 provides a fluid tight roof on top of the second plate 42, and the second surface 13 (bottom surface in Figure 6) of the second plate 41 is prevented from leakage by the fins 14 and the spacer elements 16.

Figure 7 illustrates that the second plate 41 is also provided with an elongated slit 43 which provides fluid communication between one respective opening of the two fins 14 which are located as far away from each other as possible. This elongated slit 43, extending completely through the second plate 41, is not necessary in all embodiments. If it is present, the result is (provided that dimensioning of the fluid channel is correct) a closed loop pulsating heat pipe, and if it is not present, the result is an open loop pulsating heat pipe.

As is clear from the previous explanations, the incorporation of a pulsating heat pipe into the cooling element makes it possible to obtain a cooling element with efficient cooling capabilities and which can be used in any position necessary. Such an orientation independent cooling element can directly be used to replace an old prior art cooling element which does not include any fluid circulation in the fins, because the cooling element can be arranged in any position, also in a position where the first surface with the electric component is directed upwards and the fins are directed downwards.

The production of the described cooling element can be accomplished by preparing metal plates of suitable size, by providing a solder at the locations where the parts should be attached to each other. After this the cooling element can be assembled and placed in an oven where it is heated to the melting point of the solder. Once removed from the oven, the parts attach firmly to each other while they are allowed to cool.

It is to be understood that the above description and the accompanying figures are only intended to illustrate the present invention. It will be obvious to a person skilled in the art that the invention can be varied and modified without departing from the scope of the invention.

**Claims**

1. A cooling element (10, 40) comprising:

   a first surface (11) for receiving an electric component (12),
   a second surface (13) which is provided with fins (14, 14') for forwarding a heat load received from the electric component (12) via the first surface (11) to surroundings, wherein one or more of the fins (14, 14') are provided with a flow channel (1) for passing a fluid within each respective fin, the flow channel (1) having a capillary dimension and a meandering shape for providing a pulsating heat pipe, **characterized in that** the cooling element comprises a base plate (17) with the first surface and the second surface (13) and the flow channels (1) of the different fins (14, 14') are in fluid communication with each other via the base plate (17), or the cooling element comprises a base plate (47) with the first surface (11) for receiving the electric component (12), and a second plate (41) with the second surface (13) which is provided with fins (14, 14'), the second plate (41) is stacked against the base plate (47) such that the first (11) and second (13) surfaces are facing opposite directions, the one or more fins (14, 14') provided with a flow channel comprises two respective openings (24, 25) in opposite ends of the respective flow channel (1), the openings (24, 25) facing the second plate (41), and

the second plate (41) is provided with through holes (42) at the locations of the openings (24, 25) such that one opening (24) of two adjacent fins (14) are in fluid communication with each other via one through hole (42) provided in the second plate (41).

2. The cooling element of claim 1, wherein the cooling element comprises a common inlet (4) for introducing fluid to the fluid channel (1) of the different fins (14, 14').

3. The cooling element of one of claims 1 to 2, wherein one of the fins (14) comprises a stack of plates, where the fluid channel (1) consists of a slit in a middle plate (22) and two outer plates (21, 23) on opposite sides of the middle plate provide fluid tight side walls of the fluid channel (1).

4. The cooling element of one of claims 1 to 3, wherein one of the fins (14') comprises a stack of plates, where the fluid channel (1) consists of a plurality of separate slits (35, 36) provided in a first (32) and second (33) middle plate such that the slits (35, 36) in the first (32) and second (33) middle plate partly overlap each other to provide a continuous fluid channel (1) through the fin (14'), and two outer plates (21, 23) on opposite sides of the first and second middle plate provide fluid tight side walls of the fluid channel (1).

5. The cooling element of claim 1, wherein the second plate (41) is provided with an elongated slit (43) providing fluid communication between one respective opening (24) of the two fins (14, 14') which are located farthest away from each other.

6. The cooling element of one of claims 1 to 5, wherein the cooling (40) element comprises secondary fins (44) extending between the fins (14) provided on the second surface (41).

**Patentansprüche**

1. Kühlelement (10, 40) mit:

einer ersten Oberfläche (11) zur Aufnahme einer elektrischen Komponente (12),
einer zweiten Oberfläche (13), die mit Rippen (14, 14') zur Weiterleitung einer von der elektrischen Komponente (12) empfangenen Wärmebelastung über die erste Oberfläche (11) an die Umgebung versehen ist, wobei eine oder mehrere der Rippen (14, 14') mit einem Flusskanal (1) zur Führung eines Fluids innerhalb einer jeweiligen Rippe versehen sind, welcher Flusskanal (1) eine kapillare Dimension und eine schlängelnde Form zur Ausbildung eines pulsierenden Heizrohres hat, **dadurch gekennzeichnet, dass**

das Kühlelement eine Grundplatte (17) mit der ersten Oberfläche und der zweiten Oberfläche (13) aufweist und die Flusskanäle (1) der verschiedenen Rippen (14, 14') miteinander in Fluidverbindung über die Grundplatte (17) stehen oder

das Kühlelement eine Grundplatte (47) mit der ersten Oberfläche (11) zur Aufnahme der elektrischen Komponente (12) und eine zweite Platte (41) mit der zweiten Oberfläche (13), die mit Rippen (14, 14') versehen ist, aufweist,
die zweite Platte (41) derart gegen die Grundplatte (47) gestapelt ist, dass die erste (11) und die zweite (13) Oberfläche in entgegengesetzte Richtungen zeigen,
die eine oder mehreren mit einem Flusskanal versehenen Rippen (14, 14') zwei entsprechende Öffnungen (24, 25) an entgegengesetzten Enden des jeweiligen Flusskanals (1) aufweisen, welche Öffnungen (24, 25) der zweiten Platte (41) zugewandt sind, und
die zweite Platte (41) mit Durchgangslöchern (42) an den Stellen der Öffnungen (24, 25) versehen ist, so dass eine Öffnung (24) von zwei nebeneinander liegenden Rippen (14) miteinander in Fluidverbindung über ein in der zweiten Platte (41) vorgesehenes Durchgangsloch (42) stehen.

2. Kühlelement nach Patentanspruch 1, wobei das Kühlelement eine gemeinsame Eintrittsöffnung (4) zur Einleitung von Fluid in den Fluidkanal (1) der verschiedenen Rippen (14, 14') aufweist.

3. Kühlelement nach einem der Patentansprüche 1 bis 2, wobei eine der Rippen (14) einen Stapel von Platten aufweist, wo sich der Fluidkanal (1) aus einem Schlitz in einer mittleren Platte (22) zusammensetzt und zwei äußere Platten (21, 23) auf entgegengesetzten Seiten der mittleren Platte fluiddichte Seitenwände des Fluidkanals (1) ausbilden.

4. Kühlelement nach einem der Patentansprüche 1 bis 3, wobei eine der Rippen (14') einen Stapel von Platten aufweist, wo sich der Fluidkanal (1) aus einer Vielzahl von separaten Schlitzen (35, 36) zusammensetzt, die in einer ersten (32) und zweiten (33) mittleren Platte derart vorgesehen sind, dass die Schlitze (35, 36) in der ersten (32) und zweiten (33) mittleren Platte teilweise überlappen, um einen durchgehenden Fluidkanal (1) durch die Rippe (14') auszubilden, und zwei äußere Platten (21, 23) auf entgegengesetzten Seiten der ersten und zweiten mittleren Platte fluiddichte Seitenwände des Fluidkanals (1) ausbilden.

5. Kühlelement nach Patentanspruch 1, wobei die zweite Platte (41) mit einem länglichen Schlitz (43) versehen ist, der eine Fluidverbindung zwischen einer entsprechenden Öffnung (24) der zwei Rippen (14, 14') hervorbringt, die am weitesten entfernt voneinander sind.

6. Kühlelement nach einem der Patentansprüche 1 bis 5, wobei das Kühlelement (40) sekundäre Rippen (44) aufweist, die sich zwischen den auf der zweiten Oberfläche (41) vorgesehenen Rippen (14) erstrecken.

**Revendications**

1. Elément de refroidissement (10, 40) comprenant :

une première surface (11) pour recevoir un composant électrique (12),
une seconde surface (13) qui est prévue avec des ailettes (14, 14') pour faire avancer une charge thermique reçue du composant électrique (12) via la première surface (11) vers l'environnement, dans lequel une ou plusieurs des ailettes (14, 14') sont prévues avec un canal d'écoulement (1) pour faire passer un fluide à l'intérieur de chaque ailette respective, le canal d'écoulement (1) ayant une dimension capillaire et une forme de méandre pour fournir un caloduc à pulsation, **caractérisé en ce que**
l'élément de refroidissement comprend une plaque de base (17) avec la première surface et la seconde surface (13) et les canaux d'écoulement (1) des différentes ailettes (14, 14') sont en communication de fluide entre eux, via la plaque de base (17), ou bien,
l'élément de refroidissement comprend une plaque de base (47) avec la première surface (11) pour recevoir le composant électrique (12), et une seconde plaque (41) avec la seconde surface (13) qui est prévue avec des ailettes (14, 14'),
la seconde plaque (41) est empilée contre la plaque de base (47) de sorte que les première (11) et seconde (13) surfaces se font face dans des directions opposées,
les une ou plusieurs ailettes (14, 14') prévues avec un canal d'écoulement comprennent deux ouvertures (24, 25) respectives dans des extrémités opposées du canal d'écoulement (1) respectif, les ouvertures (24, 25) faisant face à la seconde plaque (41), et
la seconde plaque (41) est prévue avec des trous débouchants (42) aux emplacements des ouvertures (24, 25) de sorte qu'une ouverture (24) des deux ailettes adjacentes (14) sont en communication de fluide entre elles via un trou débouchant (42) prévu dans la seconde plaque (41).

2. Elément de refroidissement selon la revendication 1, dans lequel l'élément de refroidissement comprend une entrée commune (4) pour introduire le fluide dans le canal de fluide (1) des différentes ailettes (14, 14').

3. Elément de refroidissement selon l'une des revendications 1 à 2, dans lequel l'une des ailettes (14) comprend un empilement de plaques, où le canal de fluide (1) se compose d'une fente dans une plaque centrale (22) et deux plaques externes (21, 23) sur les côtés opposés de la plaque centrale fournissent des parois latérales étanches au fluide du canal de fluide (1).

4. Elément de refroidissement selon l'une des revendications 1 à 3, dans lequel l'une des ailettes (14') comprend un empilement de plaques, où le canal de fluide (1) se compose d'une pluralité de fentes séparées (35, 36) prévues dans une première (32) et une seconde (33) plaque centrale de sorte que les fentes (35, 36) dans la première (32) et la seconde (33) plaque centrale se chevauchent partiellement afin de fournir un canal de fluide continu (1) à travers l'ailette (14'), et les deux plaques externes (21, 23) sur les côtés opposés des première et seconde plaques centrales fournissent des parois latérales étanches au fluide du canal de fluide (1).

5. Elément de refroidissement selon la revendication 1, dans lequel la seconde plaque (41) est prévue avec une fente allongée (43) fournissant la communication de fluide entre une ouverture (24) respective des deux ailettes (14, 14') qui sont positionnées le plus loin l'une de l'autre.

6. Elément de refroidissement selon l'une des revendications 1 à 5, dans lequel l'élément de refroidissement (40) comprend des ailettes secondaires (44) s'étendant entre les ailettes (14) prévues sur la seconde surface (41).

FIG. 1a

FIG. 1b

FIG. 2

FIG. 3

FIG. 4

FIG. 5

FIG. 6

FIG. 7

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

• US 2013077245 A1